# EUROPEAN PATENT APPLICATION

(11) **EP 4 404 281 A1**
(43) Date of publication of application: **24.07.2024**
(21) Application number: 22866749.9
(22) Date of filing: 09.09.2022
(51) Int. Cl.: H01L 31/042, H01L 31/18

(54) **FLEXIBLE PHOTOVOLTAIC CELL ASSEMBLY AND MANUFACTURING METHOD THEREFOR**

(30) Priority: 13.09.2021 CN 202111071078
(71) Applicant: Cando-Solarphotoelectric Technology (Changzhou) Co., Ltd, Changzhou City, Jiangsu 213000 (CN)
(72) Inventor: HUANG, Yaolun, hangzhou City, Jiangsu (CN)
(74) Representative: Ridderbusch, Oliver
(86) International application number: PCT/CN2022/118074
(87) International publication number: WO 2023/036288

(57) **Abstract**

The present invention relates to a flexible photovoltaic cell module and a manufacturing method thereof. The module includes a front panel, a rear panel and a photovoltaic cell layer encapsulated between the front panel and the rear panel, wherein the front panel and the rear panel are a flexible plate, the photovoltaic cell layer includes a plurality of photovoltaic cell units, the photovoltaic cell units are connected with each other in series and parallel through a flexible circuit layer, the photovoltaic cell unit is a single photovoltaic cell or a photovoltaic cell string, the flexible circuit layer is a metal foil circuit or a flexible flat cable between the front panel and the rear panel, or the flexible circuit layer is the front panel and/or the rear panel compounded with a flexible circuit. The method comprising the steps of firstly, typesetting the photovoltaic cell unit and the flexible circuit layer between the front panel and the rear panel, then carrying out lamination to obtain the photovoltaic cell module. The beneficial effect is that conductively connecting through the flexible circuit layer makes it possible to flexibly fold the crystalline silicon module in high-reliability and low-costs.

## Description

### TECHNICAL FIELD

The present invention relates to the technical field of photovoltaics, in particular a flexible photovoltaic cell module and a manufacturing method thereof.

### BACKGROUND ART

Since 2004, the photovoltaic industry has developed rapidly. The predominant photovoltaics has undergone a transition from BSF (Back Surface Field) to PERC (Passivated Emitter Rear Cell).

In recent years, PERC has developed as approaching its efficiency bottleneck. Therefore, it is imminent how to renew the next generation battery technology and upgrade the industry. At present, divers leading photovoltaics companies are laying out TOPCON cells, HJT cells, IBC, CdTe, perovskite cells, tandem cells and so on.

On the other hand, with the attention paid to the climate crisis at home and abroad, all countries have put forward specific schedules for the target of "peaking carbon dioxide emissions" and "carbon neutrality". Photovoltaic products have rapidly converted from application in large-scale power stations to distributed application, and accelerated their integration with civil life scenarios such as buildings and electric vehicles. Internationally, the International Energy Agency (IEA) has organized global technical experts and established a joint working group for the integration with buildings and new energy vehicles. In China, the Energy Bureau of the National Development and Reform Commission puts forward the idea of "promoting all over the county", which has also greatly accelerated the integration of photovoltaics with civil life scenarios.

New application scenarios for photovoltaics urgently need flexibly manufacturing photovoltaic products and flexible and lightweight photovoltaic products, moreover, higher requirements are put forward for products with reliability, ease to use and cost performance.

The manufacturing process of existing photovoltaic modules is as follows: two photovoltaic cells are connected through metal wires by ways of antarafacial interconnection. A Z-shaped metal wire is used to connect an exposal surface of a first cell (positive electrode) to a shadow surface of a second cell (negative electrode), and an exposal surface of the second cell (positive electrode) to a shadow surface of a third cell (negative electrode). Continually repeating this process enables the photovoltaic cells to be connected into a string. Next, the cells are assembled by ways of string connection and series-parallel connection, and added with encapsulants for encapsulation and lamination, finally achieving manufacturing modules.

If the existing photovoltaic module needs to change its electrical performance parameters and series-parallel setting-up, the time for switching a production line is generally more than 8 hours, without the capability to achieve the customized flexible manufacture.

In addition, the existing photovoltaic cell string can only enable a string connection of 2~3 cells once, so its production efficiency is low.

In the mode of the existing photovoltaic cell string, welding a 100~160um wafer severely brings about fragments. This type of welding fragments mainly derives from collision or stress during the welding process. Because the same welding strip should appear on the exposal surface and shadow surface of the photovoltaic module, and the action to physically arrange the welding strip in the series welding process needs to be constantly staggered with the action to arrange the photovoltaic cells, in the welding process, it is easy to destroy the photovoltaic cells with the welding strip in the process of heat expansion and contraction of the photovoltaic cells.

Furthermore, it is difficult to ensure the reliability of the existing photovoltaic flexible modules for multi-time folding, and that will result in high costs in implementation.

At present, the flexible modules on the market are mostly quasi-flexible modules, which do not have the ability to bend in large curvature many times. As with a photovoltaic panel disclosed in the CN104038142B, a conventional tinned copper strip is used between the cells of such modules to achieve a connection between photovoltaic cells. A similar condition exists in thin-film batteries, such as a CIGS battery disclosed by miasole company in US20210217913A1, which is also electrically connected through coated Cu wires. This connection does not have the ability to bend many times. Discovered in the inventor's experiment, in the case that a conventional tin-coated welding strip is bent by about 90 degrees, it will generally be broken after 30-45 time folding. This is a problem faced by most flexible modules.

The patent CN102945873B discloses that ways such as adding a wire groove enable the wire to relax to a certain extent, so as to improve folding performance, it is said that it can be folded more than 4,000 times. This method also increases the costs of manufacturing; however, it is still difficult to guarantee the performance of each product. As disclosed in the text of the patent CN110140448B by the same inventor, technical problems such as disconnection, expansion and difficulty in folding of connecting wires for solar cell chips may still occur in the product folded many times.

The patent CN110140448B discloses a military photovoltaic system that uses a flexible conductive wafer (such as a Cu wafer) to strengthen the connection between cell modules, so as to improve reliability. However, this method is highly costed and difficult to be applied for civil use, not to mention large-scale application to the integration of photovoltaics with building or the mobile photovoltaic field of electric vehicles.

### SUMMARY OF THE INVENTION

The technical problem to be solved by the present invention is difficulty in guaranteeing reliably folding the existing flexible photovoltaic module many times, and too high costs for realizing that.

The Further technical problem is that the existing photovoltaic module cannot be flexibly manufactured.

The Further technical problem is that of the existing photovoltaic module the manufacturing efficiency is low and the costs are high.

The Further technical problem is that there a serious risk of fragmentation arising from welding thin photovoltaic cells in the process of manufacturing the existing photovoltaic module.

The Further technical problem is that the existing photovoltaic module is not sufficient for aesthetic.

In order to solve the above technical problem, the technical solution of the present invention is as follows: a flexible photovoltaic cell module comprising a front panel, a rear panel and a photovoltaic cell layer encapsulated between the front panel and the rear panel, wherein the front panel and the rear panel are a flexible plate, the photovoltaic cell layer includes a plurality of photovoltaic cell units, the photovoltaic cell units are connected with each other in series and parallel through a flexible circuit layer, the photovoltaic cell unit is a single photovoltaic cell or a photovoltaic cell string, the photovoltaic cell unit is electrically connected to the flexible circuit layer through an interconnecting main gate line lead out from the photovoltaic cell inside this unit and/or through an electrode of the photovoltaic cell inside this unit, the flexible circuit layer is a metal foil circuit or a flexible flat cable between the front panel and the rear panel, or the flexible circuit layer is the front panel and/or the rear panel compounded with a flexible circuit.

As further defined, the photovoltaic cell layer is encapsulated between the front panel and the rear panel through an encapsulation adhesive layer, when the encapsulation adhesive layer is set between the photovoltaic cell layer and the flexible circuit layer, a dodging hollow corresponding to the electrical connection area between the photovoltaic cell unit and the flexible circuit layer is set on the encapsulation adhesive layer, the electrode and the interconnecting main gate line of the photovoltaic cell unit are electrically connected with the flexible circuit layer though the dodging hollow.

As further defined, the flexible circuit layer and the photovoltaic cell unit are welded together through low-temperature welding material or low-temperature curing conductive paste to form a mechanical and electrical connection, the welding temperature of the low-temperature welding layer matches the lamination temperature of the photovoltaic module, the curing temperature of the low-temperature curing conductive paste layer matches the lamination temperature of the photovoltaic module.

As further defined, the flexible circuit layer is electrically connected to the electrode of the photovoltaic cell through a gate line pattern circuit, or the photovoltaic cell is electrically connected with the flexible circuit layer through a side main gate electrode.

When it is necessary to electrically connect the flexible circuit layer with the electrodes on the exposal surface of the photovoltaic cell, the gate line pattern circuit of the flexible circuit layer can abate the shading effect of the flexible circuit layer on the exposal surface of the photovoltaic cell, and replace the interconnecting main gate line on the exposal surface of the photovoltaic cell. When the flexible circuit layer of the gate line pattern circuit is located on one side of the shadow surface, that can save on the material costs of the flexible circuit layer without affecting the conductive effect.

When it is necessary to electrically connect the flexible circuit layer with the electrodes on the exposal surface of the photovoltaic cell, the design that the photovoltaic cell is electrically connected with the flexible circuit layer through the side main gate electrode can also abate the shading effect of the flexible circuit layer on the exposal surface of the photovoltaic cell, and replace the role of the interconnecting main gate line on the exposal surface of the photovoltaic cell.

As further defined, the photovoltaic cell unit is a photovoltaic cell string, and the photovoltaic cells inside the photovoltaic cell unit are combined into a string through the interconnecting main gate lines by ways of interconnecting on the same surface.

The first technical solution for the photovoltaic cell unit of the photovoltaic module being a photovoltaic cell string is that the photovoltaic cell unit is a photovoltaic cell string composed of two double-sided photovoltaic cells, which are arranged alternately forwards and backwards, the flexible circuit layer is located on one side of the shadow surface of the photovoltaic cell layer, the exposal surfaces of the two double-sided photovoltaic cells are connected with each other through the interconnecting main gate line, and the shadow surfaces of the two double-sided photovoltaic cells are electrically connected to the flexible circuit layer through electrodes;

The second technical solution for the photovoltaic cell unit of the photovoltaic module being a photovoltaic cell string is that the photovoltaic cell unit is a single photovoltaic cell, the flexible circuit layer is located on one side of the shadow surface of the photovoltaic cell layer, the exposal surface of the photovoltaic cell is electrically connected to the flexible circuit layer through the interconnecting main gate line lead out from this surface, and the shadow surface of the photovoltaic cell is electrically connected to the flexible circuit layer through an electrode,

The third technical solution for the photovoltaic cell unit of the photovoltaic module being a photovoltaic cell string is that the photovoltaic cell unit is a single photovoltaic cell, the flexible circuit layer is located on one side of the shadow surface of the photovoltaic cell layer, both the exposal surface and shadow surface of the photovoltaic cell are electrically connected to the flexible circuit layer through the interconnecting main gate lines lead out these surfaces;

The fourth technical solution for the photovoltaic cell unit of the photovoltaic module being a photovoltaic cell string is that the photovoltaic cell unit is a single photovoltaic cell, both one sides of the exposal surface and shadow surface of the photovoltaic cell have a flexible circuit layer, which is the front panel and the rear panel compounded with a flexible circuit, both the exposal surface and shadow surface of the photovoltaic cell are electrically connected to the flexible circuit layer on the same side through electrodes, the flexible circuit layer is electrically connected to the electrode on the exposal surface of the photovoltaic cell through a gate line pattern circuit;

The fifth technical solution for the photovoltaic cell unit of the photovoltaic module being a photovoltaic cell string is that the photovoltaic cell unit is a single photovoltaic cell, both one sides of the exposal surface and shadow surface of the photovoltaic cell have a flexible circuit layer, which is the front panel and the rear panel compounded with a flexible circuit, both the exposal surface and shadow surface of the photovoltaic cell are electrically connected to the flexible circuit layer on the same side through electrodes, the photovoltaic cell is electrically connected to the flexible circuit layer through a side main gate electrode on the exposal surface;

The sixth technical solution for the photovoltaic cell unit of the photovoltaic module being a photovoltaic cell string is that the photovoltaic cell unit is a single back surface field cell, the flexible circuit layer is located on one side of the shadow surface of the photovoltaic cell layer, the positive and negative electrodes on the shadow surface of the photovoltaic cell are electrically connected to the flexible circuit layer, respectively.

As further defined, the flexible flat cable is a flexible flat cable compounded with a metal foil circuit or a flexible flat cable compounded with a conductive paste circuit, the flexible circuit is a metal foil circuit or a conductive paste circuit, the thickness of the metal foil circuit and the conductive paste circuit ranges from 10um to 100um.

Specifically, the metal foil circuit is compounded on the rear panel and/or the front panel through adherence of bonders or by ways of electroplating.

As further defined, the photovoltaic cell layer is divided into a plurality of rigid minimum folding units, each minimum folding unit contains at least one photovoltaic cell unit, there is a folding gap between the minimum folding units.

As further defined, the minimum folding unit is formed by ways of covering a rigid protective plate on one side of the exposal surface of the photovoltaic cell, the flexible circuit layer is located on one side of the shadow surface of the photovoltaic cell layer, the rigid protective plate and the photovoltaic cell unit are bonded together through an encapsulation adhesive layer, or the minimum folding unit is formed by ways of covering a protective layer of glue-drop material on one side of the exposal surface of the photovoltaic cell unit, the flexible circuit layer is located on one side of the shadow surface of the photovoltaic cell layer.

As further defined, the minimum folding units are arranged in a preset flexible curling direction of the module, the photovoltaic cell units within each minimum folding unit are arranged in a direction perpendicular to the preset flexible curling direction.

As further defined, the minimum folding unit is rectangular, and the apt-to-be-cleavage direction of the photovoltaic cell within the minimum folding unit is consistent with the length direction of the minimum folding unit.

As further defined, the connecting portion of the photovoltaic cell unit and the flexible circuit layer is located inside the minimum folding unit.

As further defined, the surface of the interconnecting main gate line and/or flexible circuit layer has low-temperature welding material, the flexible circuit layer and the photovoltaic cell unit are welded together through the low-temperature welding material to form a mechanical and electrical connection, the welding temperature of the low-temperature welding layer matches the lamination temperature of the photovoltaic module.

As further defined, the module further includes a beautification and decoration layer, which is located between the front panel and the rear panel, there is a beautification pattern on the beautification and decoration layer, the beautification pattern is located in the non-generating area that does not screen the exposal surface of the photovoltaic cell.

As further defined, the flexible flat cable is a FPC or PTF or FFC flexible flat cable, the front panel and/or the rear panel compounded with a flexible circuit is a FPC or PTF or FFC flexible circuit, small electronic components of the photovoltaic cell module are integrated on the flexible circuit layer, the photovoltaic cells inside the photovoltaic cell string are connected into a string through the interconnecting main gate line.

A manufacturing method of the flexible photovoltaic cell module, when the flexible circuit layer is a metal foil circuit or a flexible flat cable between a front panel and a rear panel, the method comprising the steps of firstly typesetting the photovoltaic cell unit and the flexible circuit layer between the front panel and the rear panel, then carrying out lamination to obtain the photovoltaic cell module, an electrical connection between the photovoltaic cell unit and the flexible circuit layer being formed during typesetting; or an electrical connection between the photovoltaic cell unit and the flexible circuit layer being completed during lamination, wherein under the action of lamination temperature and pressure, the connecting portions of the photovoltaic cell unit and the flexible circuit layer are combined with each other to form a mechanical and electrical connection through low-temperature welding material or low-temperature curing conductive paste, the low-temperature welding material or low-temperature curing conductive paste is inherent in the connecting portions of the photovoltaic cell unit and the flexible circuit layer or placed on the connecting portion during typesetting;
when the flexible circuit layer is a front panel and/or a rear panel compounded with a flexible circuit, the method comprising the steps of firstly typesetting the photovoltaic cell unit between the front panel and the rear panel, then carrying out lamination to obtain the photovoltaic cell module, an electrical connection between the photovoltaic cell unit and the flexible circuit layer being formed during typesetting; or an electrical connection between the photovoltaic cell unit and the flexible circuit layer being completed during lamination, wherein under the action of lamination temperature and pressure, the connecting portions of the photovoltaic cell unit and the flexible circuit layer are combined with each other to form a mechanical and electrical connection through low-temperature welding material or low-temperature curing conductive paste, the low-temperature welding material or low-temperature curing conductive paste is inherent in the connecting portions of the photovoltaic cell unit and the flexible circuit layer or placed on the connecting portion during typesetting.

As further defined, the preparation method of the photovoltaic cell unit includes the steps of after concurrently connecting the photovoltaic cells of a plurality of photovoltaic cell units into a string through interconnecting main gate lines by ways of interconnecting on the same surface, cutting the interconnecting main gate lines between the photovoltaic cell units to obtain each photovoltaic cell.

The beneficial effect of the present invention is as follows. Making a conductive connection between photovoltaic cell units through the flexible circuit layer enables the flexible connection between photovoltaic cells, so as to make it possible to flexibly fold the crystalline silicon module in high-reliability and low-costs. In fact, in the application for mobile phones, flexible flat cables such as FPC or PTF or FFC and circuit boards can already achieve mass production for the products capable of being reliably folded 80,000 times. It is expected that the flexible photovoltaic module of the present invention can also realize more than 80,000-time folding, therefore, it is possible to manufacture the highly-reliable products with photovoltaic crystalline silicon cells and thin-film cell modules that can be folded and winded.

The photovoltaic cells in the module can be connected together in a string or in a whole board through the interconnecting main gate lines by ways of interconnection on the same surface, and then cut into required individual photovoltaic cell units, even it is possible to design out the module that does not need the interconnecting main gate line, greatly improving production efficiency.

In addition, this design avoids the interconnecting main gate lines from concurrently connecting the exposal surface and the shadow surface of adjacent photovoltaic cells, greatly lowering the occurrence of fragments, raising the non-defective ratio of module manufacturing and reducing costs. It is of great significance for the application of thinning a high-efficient cell.

Integrating small electronic components such as surface mount diodes and other flexible or small electronic components at the flexible circuit layer enables the manufacturing process to reduce and the manufacturing costs to decrease.

Connecting the photovoltaic module to an internal circuit through the front panel and/or rear panel compounded with the flexible circuit enables the internal circuit connection of the photovoltaic modules to change through the transfer of the rear panel and/or front panel with diverse circuit patterns from one to another, so that the performance parameters of photovoltaic modules alter and the switching time for entire production is about equal to zero, in this way the flexible manufacturing of photovoltaic modules comes true.

### BRIEF DESCRIPTION OF THE DRAWINGS

The present invention is further described in combination with the drawings and examples as follows.
FIG. 1a is a stereoscopic state structure schematic diagram of Example 1 according to the present invention.
FIG. 1b is a side-state structure schematic diagram of Example 1 according to the present invention.
FIG.1c is a structure diagram of the photovoltaic module described as the first specification in Example 1 according to the present invention.
FIG.1d is a structure diagram of the rear panel of the photovoltaic module described as the first specification in Example 1 according to the present invention.
FIG.1e is a structure diagram of the photovoltaic module described as the second specification in Example 1 according to the present invention.
FIG. 1f is a structure diagram of the rear panel of the photovoltaic module described as the second specification in Example 1 according to the present invention.
FIG.2 is a structure diagram of the rear panel of the photovoltaic module in Example 2 according to the present invention.
FIG.3a is a structure diagram of the photovoltaic module in Example 3 according to the present invention.
FIG.3b is a structure diagram of the rear panel of the photovoltaic module in Example 3 according to the present invention.
FIG.4a is a stereoscopic state structure schematic diagram of Example 4 according to the present invention.
FIG. 4b is a side-state structure schematic diagram of Example 4 according to the present invention.
FIG.4c is a structure diagram of the photovoltaic module in Example 4 according to the present invention.
FIG.4d is a structure diagram of the rear panel of the photovoltaic module in Example 4 according to the present invention.
FIG.5a is a structure diagram of the photovoltaic cells being welded on the same surface into a string in Example 5 according to the present invention.
FIG.5b is a structure diagram of the photovoltaic cells welded on the same surface into the string being cut into the photovoltaic cell units in Example 5 according to the present invention.
FIG.5c is a structure schematic diagram of Example 5 according to the present invention.
FIG.5d is a structure diagram of the photovoltaic module in Example 5 according to the present invention.
FIG.6 is a structure diagram of the photovoltaic module in Example 6 according to the present invention.
FIG.7a is a structure diagram of the photovoltaic module in Example 7 according to the present invention.
FIG.7b is a structure diagram of the front panel of the photovoltaic module in Example 7 according to the present invention.
FIG.7c is a structure diagram of the rear panel of the photovoltaic module in Example 7 according to the present invention.
FIG.8 is a structure diagram of the rear panel of the photovoltaic module in Example 8 according to the present invention.
FIG.9 is a structure diagram of the rear panel of the photovoltaic module in Example 9 according to the present invention.
FIG. 10a is a stereoscopic state structure schematic diagram of the photovoltaic cells welded in series through the interconnecting main gate line in the art.
FIG. 10b is a side-state structure schematic diagram of the photovoltaic cells welded in series through the interconnecting main gate line in the art.

Where, 1-photovoltaic cell; 1-1-double-sided photovoltaic cell; 1-2-back surface field cell; 2-interconnecting main gate line; 3-metal foil circuit; 4-front panel; 5-rear panel; 6-minimum folding unit; 6-1-rigid protective plate;7-surface mount diode; 8-junction box.

### DETAILED DESCRIPTION OF THE PREFERRED EMBODIMENTS

In the prior art, the adjacent photovoltaic cells 1 of the photovoltaic module are connected with each other in series to form a cell string through the interconnecting main gate line 2, and the cell strings are connected with each other in parallel through a bus bar to complete the electrical connection of the photovoltaic cell 1 in the module, but this method does not enable flexible manufacturing.

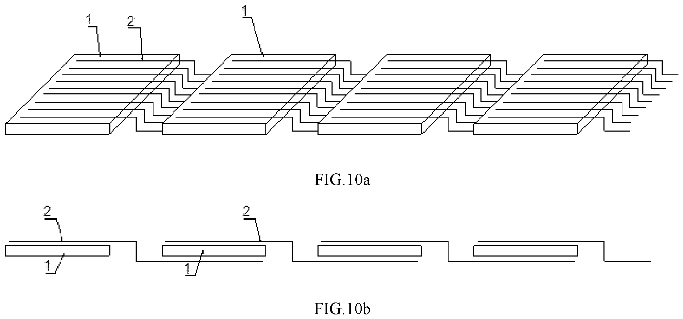

In addition, the adjacent photovoltaic cells 1 are connected with each other in series through the interconnecting main gate line 2, but this method results in a common problem that the edges of the interconnecting main gate line 2 and the photovoltaic cell 1 are mutually restrained by each other, this structure not only slows down the manufacturing speed, but also raises the dropping of the non-defective ratio caused by fragmentation. As shown in FIG. 10a, conventional PERC cells are spaced apart and staggered upwards and downwards be means of the interconnecting main gate line 2. FIG. 10b gives a side view of the structure of FIG. 10a.

The present invention can be implemented in any cell structure, whether it is a PERC cell, a TOPCON cell, a heterojunction cell, or an IBC or MWT cell.

### EXAMPLE 1

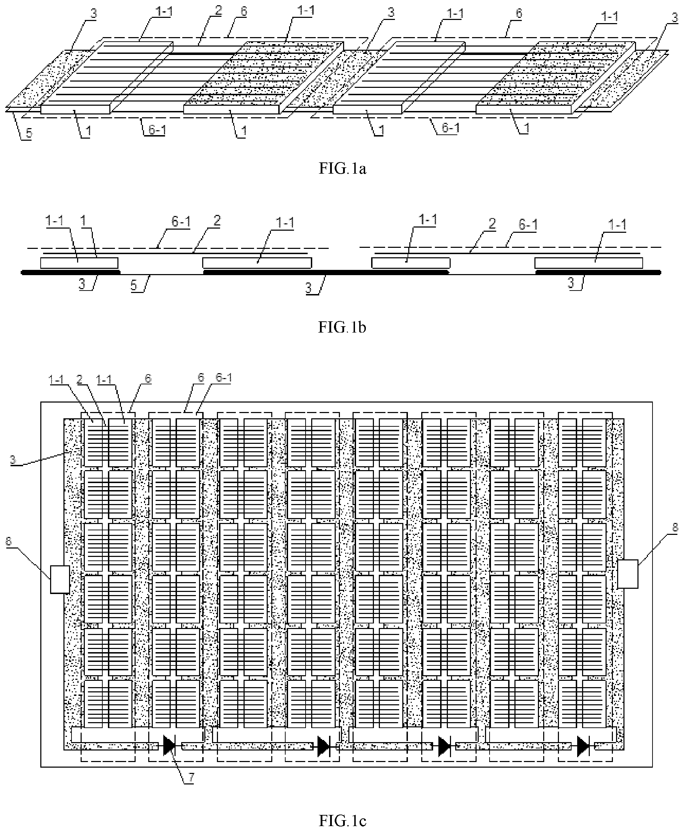

As shown in FIGS.1a~1f, a flexible photovoltaic cell module includes the front panel 4, the rear panel 5 and a photovoltaic cell layer encapsulated between the front panel 4 and the rear panel 5, the front panel and the rear panel are a flexible plate, and the photovoltaic cell layer includes a plurality of photovoltaic cell units, the photovoltaic cell units are connected with each other in series and parallel through a flexible circuit layer, which is the rear panel 5 of the compound metal foil circuit 3, the photovoltaic cell unit is a photovoltaic cell string composed of two double-sided photovoltaic cells 1-1, which are arranged alternately forwards and backwards, of the two double-sided photovoltaic cells 1-1 the exposal surfaces are connected into a string through the interconnecting main gate line 2, and the shadow surfaces are electrically connected to the metal foil circuit 3 on the rear panel 5 through electrodes.

One double-sided photovoltaic cells 1-1 is divided into two, forming the double-sided photovoltaic cells 1-1, when the photoelectric conversion efficiency/current intensity ratio of the front surface and the back surface of an used double-sided photovoltaic cells 1-1 is x:y, the area ratio of the double-sided photovoltaic cells 1-1 of which the front surface is upward and the double-sided photovoltaic cells 1-1 of which the back surface is upward is y:x.

The thickness of the metal foil circuit 3 ranges from 10um to 100um.

The metal foil circuit 3 is compounded on the rear panel 5 through adherence of bonders or by ways of electroplating, the way of electroplating is specified as firstly sputtering a metallic seed layer on the rear panel 5 then electroplating. The metal foil circuit 3 generally has a circuit pattern formed from an electroplated metal foil or a rolled metal foil via the printed circuit board process.

An encapsulation adhesive layer is set between the front panel 4 and the photovoltaic cell layer, and between the photovoltaic cell layer and the rear panel 5, it encapsulates the photovoltaic cell layer between the front panel 4 and the rear panel 5, a dodging hollow corresponding to the electrical connection area between the photovoltaic cell unit and the metal foil circuit 3 is set on the encapsulation adhesive layer, the electrode of the photovoltaic cell unit is electrically connected with the metal foil circuit 3 though the dodging hollow, and the surface of the metal foil circuit 3 is provided with low-temperature welding material, and the welding temperature of the low-temperature welding layer matches the lamination temperature of the photovoltaic module. The metal foil circuit 3 and the photovoltaic cell unit are welded together through the low-temperature welding material to form a mechanical and electrical connection.

The metal foil circuit 3 may be made from a copper foil, a gold foil, a platinum foil, an aluminum foil, a tin foil, a tungsten foil, or a silver foil, generally from the copper foil, and its surface is electroplated and coated with low-temperature welding material. The low-temperature welding material is a low-melting alloy, such as Sn, Bi, In, SnxPby, or SnBiAg.

The rear panel 5 compounded with the metal foil circuit 3 is an FPC flexible circuit board.

The photovoltaic cell layer is divided into a plurality of rigid minimum folding units 6, each minimum folding unit 6 contains at least one photovoltaic cell unit, there is a folding gap between the minimum folding units 6, the connecting portion between the photovoltaic cell and the metal foil circuit 3 is located inside the minimum folding unit 6.

The minimum folding unit 6 is formed by ways of covering the rigid protective plate 6-1 on one side of the exposal surface of the photovoltaic cell, and the rigid protective plate 6-1 and the photovoltaic cell are bonded together through the encapsulation adhesive layer.

The rigid protective plate 6-1 may have a"body armor" structure formed by ways of piling acrylic, glass fiber reinforced acrylic, or multi-layer ultra-thin glass with hot melt adhesive material into multiple layers.

The photovoltaic cell layer is divided into a plurality of minimum folding units 6 arranged in the preset flexible curling direction of the module, the photovoltaic cell units 1 within each minimum folding unit 6 are arranged in a direction perpendicular to the preset flexible curling direction. In this example, the flexible curling direction is preset to be the length direction of the photovoltaic module, and the photovoltaic cell units 1 within the minimum folding unit 6 are arranged in the width direction of the photovoltaic module.

The minimum folding unit 6 is rectangular, and the apt-to-be-cleavage direction of the photovoltaic cell 1 within the minimum folding unit 6 is consistent with the length direction of the minimum folding unit 6.

Small electronic components of the photovoltaic module are integrated on the rear panel 5, specifically the surface mount diode 7.

The structural design of the flexible photovoltaic cell module in this example enables a production line to produce flexible photovoltaic cell modules having diverse specifications only through the transfer of the rear panels 5 with diverse circuit patterns, instead of a change to the specification of the photovoltaic cell unit.

The manufacturing method of the flexible photovoltaic cell module of this example is as follows: welding the photovoltaic cells in the photovoltaic cell unit into a string one by one through the interconnecting main gate line 2, and then typesetting the photovoltaic cell unit, the rigid protective plate 6-1 and the encapsulation adhesive layer between the front panel 4 and the rear panel 5, next laminating them, during lamination, enabling the low-temperature welding material to melt under the action of the lamination temperature, and enabling the connecting portions of the photovoltaic cell and the metal foil circuit 3 to be bonded together under the pressure of the encapsulation adhesive layer, next forming a mechanical and electrical connection by ways of welding with the low-temperature welding material, finally obtaining a flexible photovoltaic cell module after completing lamination.

Of course, after preparing all photovoltaic cells, firstly using the photovoltaic cells to make the minimum folding units 6, and then typesetting and laminating the minimum folding units 6.

Of course, this example can also be altered as follows: the photovoltaic cells 1 of a plurality of photovoltaic cell units are concurrently welded into a cell string through the interconnecting main gate line 2 on one side of the exposal surface welded on the same surface, and each photovoltaic cell unit is obtained by ways of cutting the interconnecting main gate line 2 between the photovoltaic cell units.

The manufacturing process for flexible photovoltaic cell modules also includes the steps of installing the junction box 8 and optionally encapsulating edges, which are as same as the existing technology.

A process of using a high double-sided yield PERC cell to manufacture a flexible and foldable single-sided photovoltaic module is taken as an example to further describe this example.

### S 1. Selecting and preparing the photovoltaic cell 1:

Selecting a 210mm sized 9-gate PERC cell having efficiency of 23% and double-sided yield of 75%. Considering current matching for front illumination, cutting the photovoltaic cell 1 in the orientation of one edge by laser through a non-destructive cutting method into two specifications, a big one and a small one, of which the area ratio is 100:75. Of the double-sided photovoltaic cells 1-1 of which the front surface is upward the length is 210mm and the width is 90mm, and of the double-sided photovoltaic cells 1-1 of which the rear surface is upward the length is 210mm and the width is 120mm, as shown in FIG.1a.

### S2.Preparing the photovoltaic cell unit and the minimum folding unit 6:

Sorting the double-sided photovoltaic cells 1-1 of which the front surface is upward by a front surface radio, giving a result of the front surface being upward. Sorting the double-sided photovoltaic cells 1-1 of which the rear surface is upward by a rear surface radio, giving a result of the rear surface being upward. As shown in FIGS.1a and 1b, welding the front surface of the double-sided photovoltaic cells 1-1 of which the front surface is upward with the rear surface of the double-sided photovoltaic cells 1-1 of which the rear surface is upward through 9 interconnecting main gate lines 2 to form a photovoltaic cell unit. The interconnecting main gate lines 2 are on the same side of the two double-sided photovoltaic cells 1-1. The interconnecting main gate line 2 is a metal welding strip.

In line with the dashed frame in FIG. 1a, a glass fiber reinforced acrylic plate, which is 1.5mm thick, and of which the area is consistent with the dashed frame, is laid on the exposal surface and acts as the rigid protective plate 6-1 through an EVA hot melt adhesive. In this way, the photovoltaic cell unit and the rigid protective plate 6-1 form the minimum folding unit 6 together.

### S3. Preparing the rear panel 5 of the compound metal foil circuit 3:

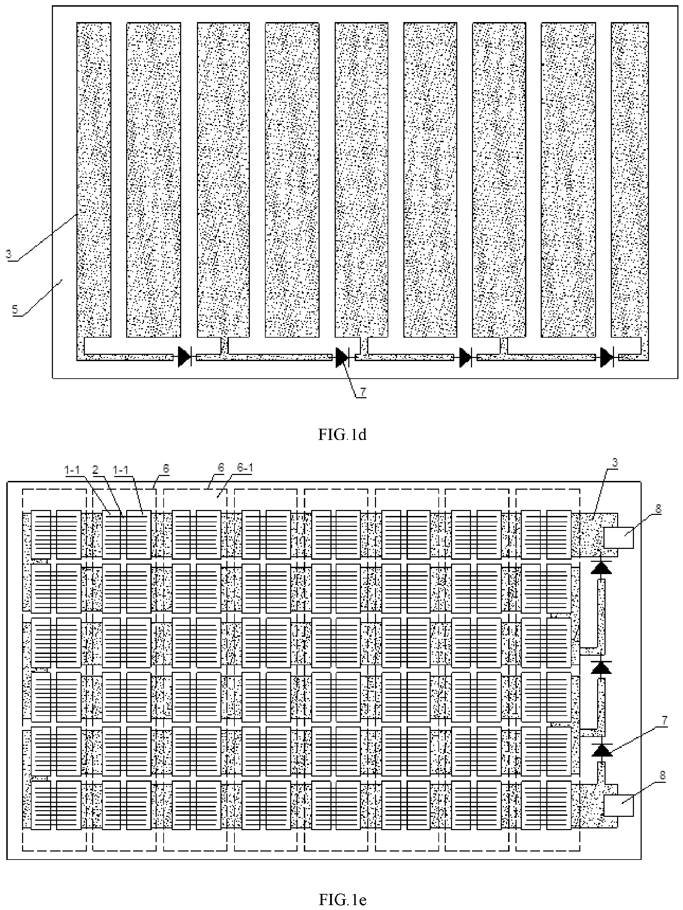

Using the opaque PO board produced by Zhejiang Zhongju Company as a substrate, which is compounded with 1mm glass fiber epoxy resin compound reinforcing material FR4, then with a metal foil, which forms a circuit pattern through the printed circuit board process, so as to form the rear panel 5 of the compound metal foil circuit 3. The layers of the metal foil circuit 3 from the inside to the outside are respectively Ni (200u)/Cu(35um)/Sn(100u)/SnBiAg(15um), the circuit pattern of the metal foil circuit 3 as shown in FIG.1d only covers part of the rear panel 5, the low melting point alloy SnBiAg exists in the form of welding points, which are designed to cooperate with the welding points on the shadow surface of the photovoltaic cell 1, only covering part of the metal foil circuit 3. As shown in FIG.1d, the surface mount diode 7 is welded on the metal foil circuit 3 in accordance with the design for module products.

### S4. Typesetting:

As shown in FIGS. 1a and 1b, firstly laying the rear panel 5 on a typesetting workbench, then laying a 500um thick EVA hot melt adhesive as the encapsulation adhesive layer, this EVA hot melt adhesive layer leaving a dodging hollow on the portion of the metal foil circuit 3 that needs to make an electrical connection with the photovoltaic cell 1. In order to reduce the fluidity of this EVA hot melt adhesive and make automatized operation easier, this EVA hot melt adhesive is an EVA hot melt adhesive having a pre-crosslinking radio of 20%.

Then laying the minimum folding units 6, enabling the length direction of the rear panel 5 to have 8 rows of minimum folding units 6 and each minimum folding unit 6 to have 6 photovoltaic cell units, which are ready to combine with the metal foil circuit 3 on the rear panel 5 to form a series circuit.

Laying a 500um thick EVA hot melt adhesive layer above the minimum folding units 6 again as the encapsulation adhesive layer. Then laying an ETFE film as the front panel 4.

### S5. Laminating and welding parts and installing the junction box 8:

Laminating the above ready-typeset intermediate parts at 150°C, at the same time as lamination, competing the conductive combination of the metal foil circuit 3 of the rear panel 5 and the electrode of the shadow surface of the photovoltaic cell 1 through the welding point of the low melting point alloy SnBiAg.

Then installing the junction box 8, and optionally encapsulating edges.

In this way, of the flexible photovoltaic module the manufacture is completed. The already- manufactured module can be reliably folded many times, and it is expected that it can be folded more than 10,000 times.

In S1-S5 of Example 1, S1-S3 are production preparation stages without sequence, and S4-S5 are actual production stages for the module.

When it is necessary to change the specifications of flexible photovoltaic cell modules, this example enables a production line to produce flexible photovoltaic cell modules having diverse specifications only through the transfer of the rear panels 5 of the metal foil circuit 3 with diverse circuit patterns, instead of any other changes.

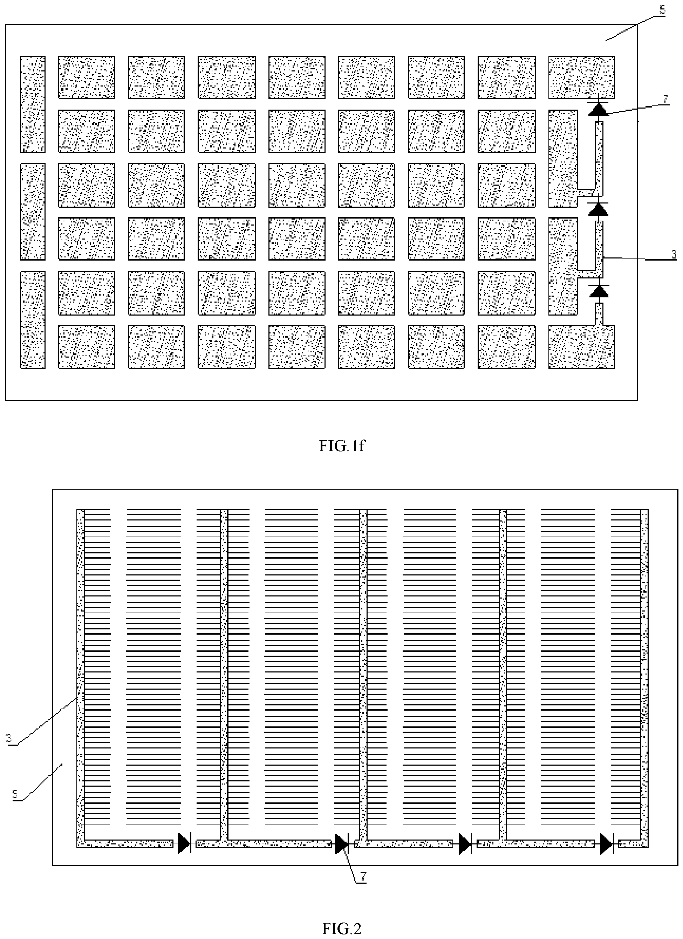

FIG.1d is the first circuit pattern of the metal foil circuit 3 of the rear panel 5 in Example 1, FIG.1f is the second circuit pattern, and the open-circuit voltage of the photovoltaic module using the rear panel 5 with the first circuit pattern is about 11V. FIG. 1e shows that the open-circuit voltage of the photovoltaic module using the rear panel 5 with the second circuit pattern is about 66V. there is 6 times between the two, which have completely different electrical performance parameters. The only change in the manufacturing process is the replacement of the rear panel 5, and the switching time for entire production is approximately equal to zero, in this way the flexible manufacturing of photovoltaic modules comes true.

### EXAMPLE 2

A flexible photovoltaic cell module shown in this example is basically the same as Example 1, except that a third circuit pattern of the rear panel 5 is provided, as shown in FIG.2, Compared with the first circuit pattern, this third circuit pattern changes the entire continuous pattern into a gate line pattern in the conductive orientation, the metal foil circuit 3 is electrically connected to the electrode of the photovoltaic cell 1 through a gate line pattern circuit. Without affecting the conductive effect, this design may save the material costs of the metal foil circuit 3.

### EXAMPLE 3

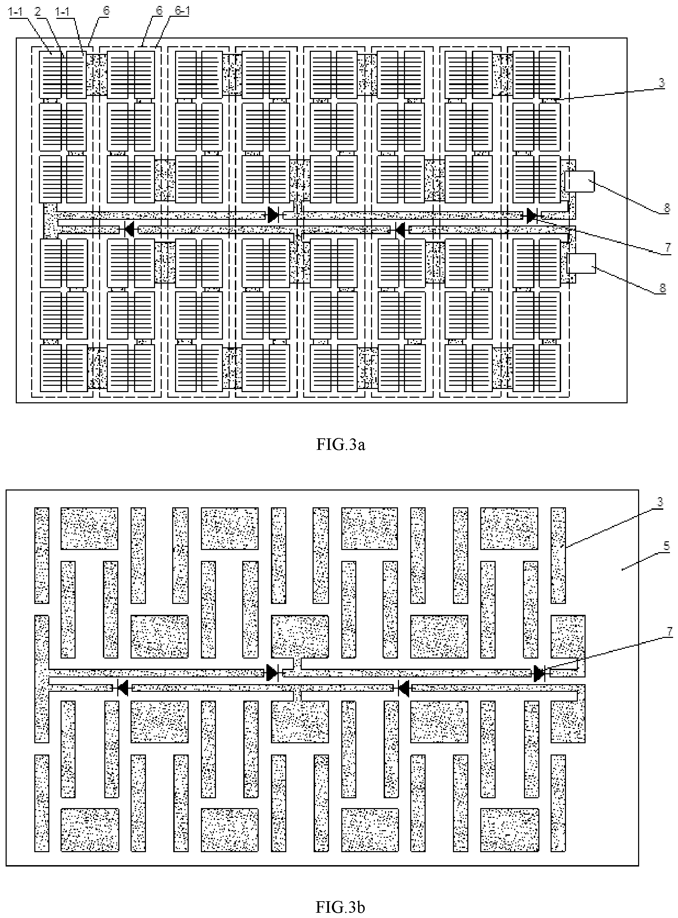

A flexible photovoltaic cell module as shown FIGS.3a and 3b in this example is basically the same as Example 1, except that the flexible photovoltaic cell module in this example is a flexible and foldable single-sided module made of high double-sided HJT cells.

Selecting a 158mm sized 9-gate HJT cell having efficiency of 23% for the flexible photovoltaic cell module in this example. Enabling the front surface radio and the rear surface radio of the cell to be consistent through the optimization of the battery process. Cutting the photovoltaic cell 1 in the orientation of one edge by laser through a non-destructive cutting method into two halves as same with each other in size, 158mm long and 79mm wide.

Sorting the photovoltaic cells by a front-rear surface radio. As shown in FIG.3a, pairwise welding the front surface of the double-sided photovoltaic cells 1-1 of which the front surface is upward with the rear surface of the double-sided photovoltaic cells 1-1 of which the rear surface is upward through 9 interconnecting main gate lines 2. Changing the design cooperating with the rear panel 5 between the upper three photovoltaic cell units and the lower three photovoltaic cell units within the minimum folding unit 6 to leave a gap.

The circuit pattern of the metal foil circuit 3 of the rear panel 5 and the surface mount diode 7 are shown in FIG.3b.

The encapsulation adhesive layer above the minimum folding unit 6 is a 500um thick PVB film.

In this example, changing the design of the metal foil circuit 3 of the rear panel 5 enables the flexible module to greatly improve on the ability to prevent shadowing under the premise of maintaining a manufacturing process basically unchanged. In the case where a certain 1/4 corner is shadowed, it can maintain 75% of the generating capacity, the photovoltaic module of the rear panel 5 using the first circuit pattern in Example 1 only leaves 33% of the generating capacity under the same conditions of shadowing. This gives us an inspiration: we can absolutely customize the production of corresponding special modules based on the rear panel 5 containing the metal foil circuit 3 in the light of a product application scenario, so as to realize softwareization of manufacturing hardware and flexibility and intelligentization of production.

The above example is mainly for the cells having a double-sided yield more than 75% and is currently applicable to the predominant cells such a PERC cell, a TOPCON cell, and a HJT, CIGS, perovskite or tandem cell in the industry.

In Examples 1-3, both positive electrode and negative electrode of the photovoltaic cell 1 exist on one surface of the photovoltaic module. The photovoltaic cell 1 has two states: the front surface is upward and downward. Generally speaking, that will result in loss of some efficiency and power generation.

In the following examples, we shall emphasize the description how to achieve the effect of the invention and ensure no loss of efficiency and power generation in the case that the positive and negative electrodes of the cell are on diverse surfaces.

### EXAMPLE 4

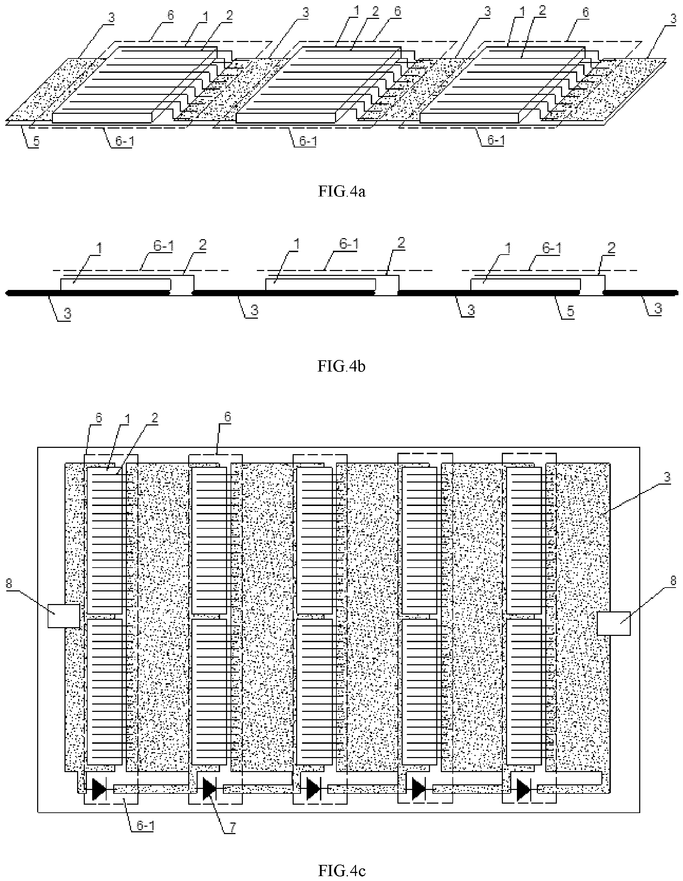

A flexible photovoltaic cell module in this example is basically the same as Example 1, except that: as shown in FIGS.4a, 4b and 4c, the photovoltaic cell unit is a single photovoltaic cell 1, the exposal surface of the photovoltaic cell 1 is electrically connected to the metal foil circuit 3 on the rear panel 5 through the interconnecting main gate lines 2 lead out from this surface, and the shadow surface of the photovoltaic cell 1 is electrically connected to the metal foil circuit 3 on the rear panel 5 through electrodes.

A process of using a HJT whole square flat cell to manufacture a flexible and foldable single-sided photovoltaic module is taken as an example to further describe this example.

### S 1. Selecting and preparing the photovoltaic cell unit:

Selecting a 158mm sized HJT whole square flat cell having efficiency of 24.2%, cutting the photovoltaic cell 1 by laser through a non-destructive cutting method into 10 halves as same with each other in size, 158mm long and 15.8mm wide. As shown in FIG.4a, the photovoltaic cell 1 of which the front surface is covered with many 0.18mm diameter fine metal welding strips used as the interconnecting main gate lines 2, is used as the photovoltaic cell for this example. These fine metal welding strips on the front surface of the photovoltaic cell are led out beyond the side of the photovoltaic cell 1. The surfaces of these metal fine welding trips are coated with SnBiAg coating.

### S3. Preparing the rear panel 5 of the compound metal foil circuit 3

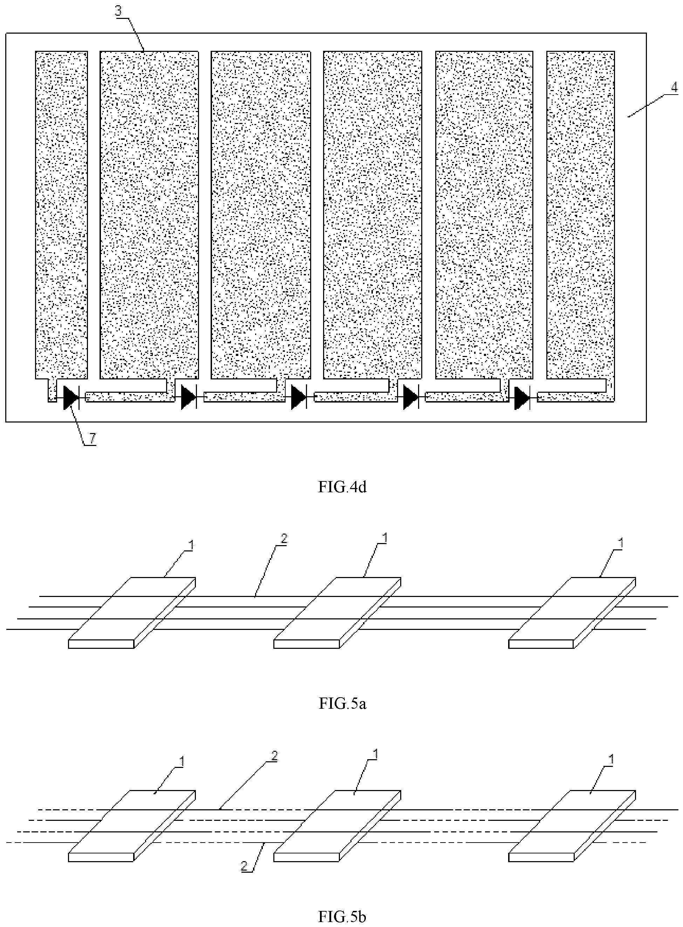

Using the opaque PO board produced by Zhejiang Zhongju Company as a substrate, which is compounded with 1mm glass fiber epoxy resin compound reinforcing material FR4, then with a metal foil, which forms a circuit pattern through the printed circuit board process, so as to form the rear panel 5 of the compound metal foil circuit 3. The layers of the metal foil circuit 3 from the inside to the outside are respectively Ni (200u)/Cu(35um)/Sn(100u)/SnBiAg(15um), the circuit pattern of the metal foil circuit 3 as shown in FIG.4d only covers part of the rear panel 5, the low melting point alloy SnBiAg exists in the form of welding points, which are designed to cooperate with the welding points on the shadow surface of the photovoltaic cell 1, only covering part of the metal foil circuit 3. The surface mount diode 7 is welded on the metal foil circuit 3 in accordance with the design for module products.

### S4. Typesetting:

As shown in FIGS.4a and 4b, firstly laying the rear panel 5 on a typesetting workbench, then laying a 500um thick EVA hot melt adhesive as the encapsulation adhesive layer, this EVA hot melt adhesive layer leaving a dodging hollow on the portion of the metal foil circuit 3 that needs to make an electrical connection with the photovoltaic cell 1. In order to reduce the fluidity of this EVA hot melt adhesive and make automatized operation easier, this EVA hot melt adhesive is an EVA hot melt adhesive having a pre-crosslinking radio of 20%.

Then laying the photovoltaic cell units, in line with the dashed frame in FIGS.4a and 4b, firstly laying an EVA hot melt adhesive, next laying a 1.5mm thick glass fiber reinforced acrylic plate, of which the area is consistent with the dashed frame, on the exposal surface and acts as the rigid protective plate 6-1, of which the length is about 330 mm and the width is about 20mm.

Laying above a 500um thick PVB film acting as the encapsulation adhesive layer again, then laying a 0.3mm~1.5mm thick ETFE film acting as the front panel 4.

### S5. Laminating and welding parts and installing the junction box 8:

Laminating the above ready-typeset intermediate parts at 150°C, at the same time as lamination, competing the conductive combination of the metal foil circuit 3 of the rear panel 5 and the electrode of the shadow surface of the photovoltaic cell 1 through the welding point of the low melting point alloy SnBiAg.

Then installing the junction box 8, and encapsulating edges by butyl adhesives.

In this way, the manufacture of the flexible module is completed.

In this example, the connecting portion of the interconnecting main gate line 2 of the photovoltaic cell unit and the metal foil circuit 3 is located inside the minimum folding unit 6. Of course, it is also feasible for the connecting portion of the interconnecting main gate line 2 of the photovoltaic cell unit and the metal foil circuit 3 to slightly deviate from the minimum folding unit 6, because generally only the middle position of the folding gap between the minimum folding units 6 acts as the folding position, which can be frequently folded.

### EXAMPLE 5

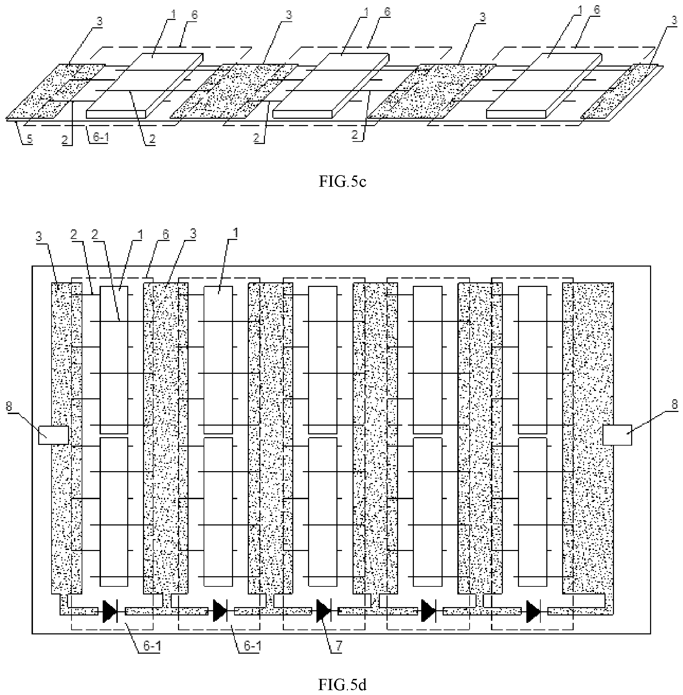

A flexible photovoltaic cell module as shown in FIG.5d is basically the same as Example 4, except that: both the exposal surface and shadow surface of the photovoltaic cell 1 of the photovoltaic cell unit are electrically connected to the metal foil circuit 3 on the rear panel 5 through the interconnecting main gate lines 2 lead out from these surfaces.

As shown in FIGS.5a and 5b, the photovoltaic cells 1 of a plurality of photovoltaic cell units are concurrently welded into a cell string through the interconnecting main gate line 2 on one side of the exposal surface and on one side of the shadow surface both welded on the same surface, and each photovoltaic cell is obtained by ways of cutting the interconnecting main gate line 2 between the photovoltaic cell units.

A process of using a HJT whole square flat cell to manufacture a flexible and foldable single-sided photovoltaic module is taken as an example to further describe this example.

### S 1. Selecting and preparing the photovoltaic cell 1:

Selecting a 158mm sized HJT whole square flat cell having efficiency of 24.2%, cutting the photovoltaic cell 1 by laser through a non-destructive cutting method into 10 halves as same with each other in size, 158mm long and 15.8mm wide.

### S2.Preparing the photovoltaic cell unit:

Firstly wiring the interconnecting main gate line 2 on the rear surface of the photovoltaic cell 1 on a series welding table, so as to enable the interconnecting main gate line 2 of the rear surface to correspond to the position of the main gate of the rear surface of the photovoltaic cell 1, and to be spaced by 8.7mm. The interconnecting main gate line 2 is a 0.25 mm diameter copper welding strip coated with SnBiAg, and each photovoltaic cell 1 corresponds to three copper welding strips.

Then arranging the photovoltaic cells 1 of a plurality of photovoltaic cell units on a series welding table, wiring the interconnecting main gate line 2 of the front surface of the photovoltaic cell 1, so as to enable the interconnecting main gate line 2 of the front surface to correspond to the position of the main gate of the front surface of the photovoltaic cell 1, and to be spaced by 8.7mm. The interconnecting main gate line 2 is a 0.25 mm diameter copper welding strip coated with SnBiAg, and each photovoltaic cell 1 corresponds to three copper welding strips.

There is a certain horizontal displacement between interconnecting main gate line 2 of the front surface of the photovoltaic cell 1 and interconnecting main gate line 2 of the rear surface of the photovoltaic cell 1, so as to prevent the two from being possibly staggered and connected, thereby avoiding a short circuit.

Through the above process, the photovoltaic cells 1 of a plurality of photovoltaic cell units are concurrently welded in series into a cell string by ways of interconnection on the same surface, as shown in FIG. 5a.

As shown in FIG. 5b, after using a die cutter to cut the portion with the dotted lines and removing the surplus interconnecting main gate line 2, the required photovoltaic cells can be obtained.

### S3. Preparing the rear panel 5 of the compound metal foil circuit 3 :

Using the opaque PO board produced by Zhejiang Zhongju Company as a substrate, which is compounded with 1mm glass fiber epoxy resin compound reinforcing material FR4, then with a metal foil, which forms a circuit pattern through the printed circuit board process, so as to form the rear panel 5 of the compound metal foil circuit 3. The layers of the metal foil circuit 3 from the inside to the outside are respectively Ni (200u)/Cu(35um)/Sn(100u)/SnBiAg(15um), the circuit pattern of the metal foil circuit 3 as shown in FIG.1d only covers part of the rear panel 5, the low melting point alloy SnBiAg exists in the form of welding points, which are designed to cooperate with the welding points on the shadow surface of the photovoltaic cell 1, only covering part of the metal foil circuit 3. As shown in FIG.5d, the surface mount diode 7 is welded on the metal foil circuit 3 in accordance with the design for module products.

### S4. Typesetting:

As shown in FIG.5c, firstly laying the rear panel 5 on a typesetting workbench, then laying a 500um thick EVA hot melt adhesive as the encapsulation adhesive layer, this EVA hot melt adhesive layer leaving a dodging hollow on the portion of the metal foil circuit 3 that needs to make an electrical connection with the photovoltaic cell 1. In order to reduce the fluidity of this EVA hot melt adhesive and make automation easier, this EVA hot melt adhesive is an EVA hot melt adhesive having a pre-crosslinking radio of 20%.

Then laying the photovoltaic cell units, in line with the dashed frame in FIG.5c, firstly laying an EVA hot melt adhesive, next laying a 1.5mm thick glass fiber reinforced acrylic plate, of which the area is consistent with the dashed frame, on the exposal surface and acts as the rigid protective plate 6-1, of which the length is about 330 mm and the width is about 20mm.

Laying above a 500um thick PVB film acting as the encapsulation adhesive layer again, then laying a 0.3mm~1.5mm thick ETFE film acting as the front panel 4.

### S5. Laminating and welding parts and installing the junction box 8:

Laminating the above ready-typeset intermediate parts at 150°C, at the same time as lamination, competing the conductive combination of the metal foil circuit 3 of the rear panel 5 and the electrode of the shadow surface of the photovoltaic cell 1 through the welding point of the low melting point alloy SnBiAg.

Then installing the junction box 8, and encapsulating edges by butyl adhesives.

In this way, the manufacture of the flexible module is completed.

### EXAMPLE 6

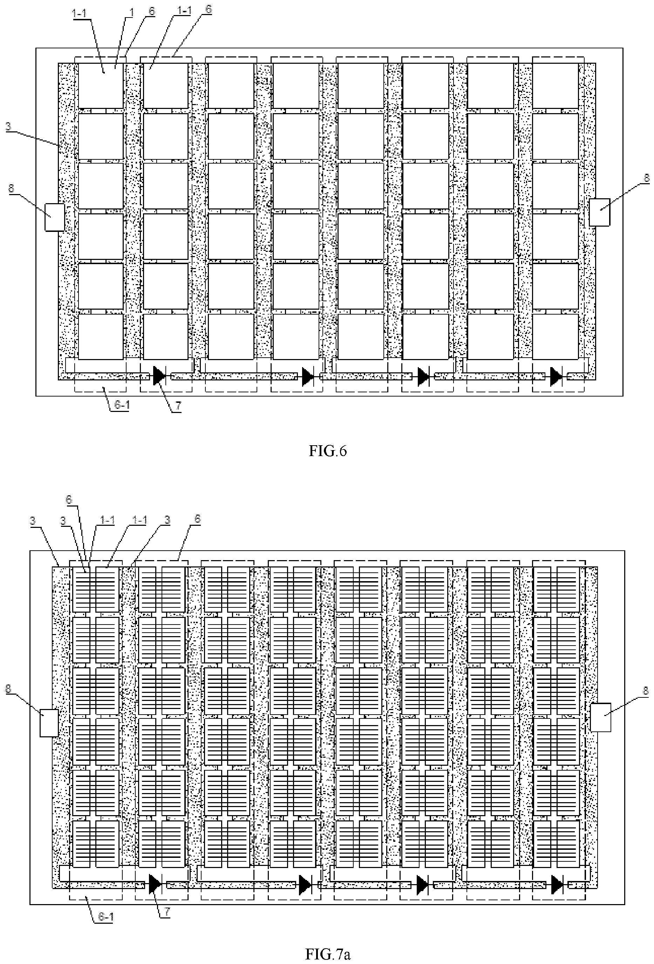

A flexible photovoltaic cell module as shown in FIG.6 is basically the same as Example 1, except that: the photovoltaic module uses the back surface field cell 1-2, which includes MWT, IBC, HBC or similar cells, the photovoltaic cell is the single back surface field cell 1-2. The positive and negative electrodes on the rear surface of the back surface field cell 1-2 are electrically connected to the metal foil circuit 3 on the rear panel 5.

### EXAMPLE 7

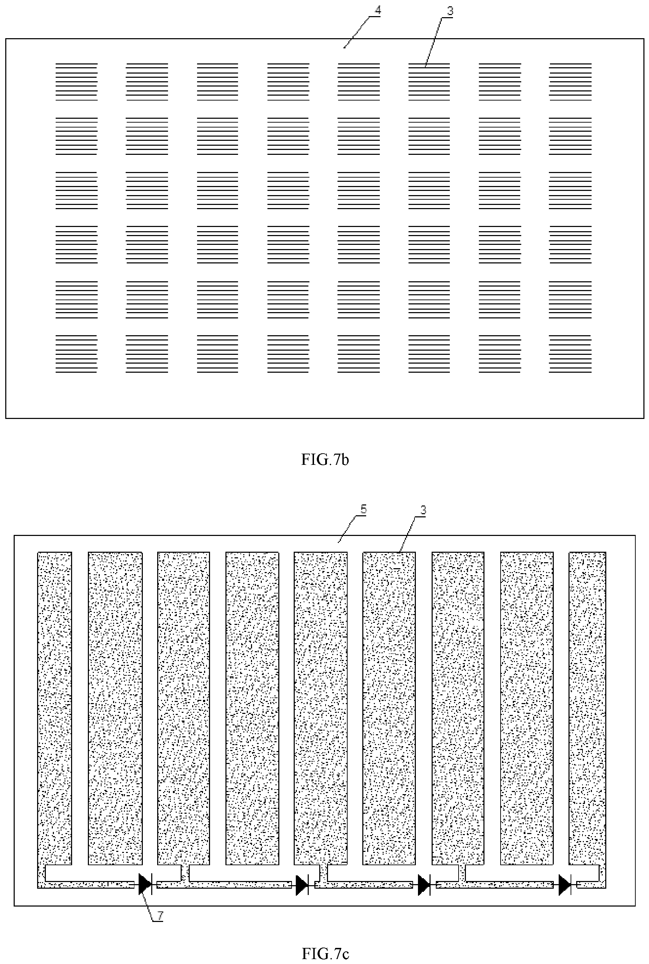

As shown in FIG.7a, 7b and 7c, a flexible photovoltaic cell module as same as the above Examples 1-6, in which the metal foil circuit 3 are compounded on the rear panel 5, the example 7 is basically the same as Example 1, except that: as shown in FIG.7b, the front panel 4 is also compounded with the metal foil circuit 3. The metal foil circuit 3 on the front panel 4 replaces the interconnecting main gate line 2 in Example 1, so that there is no interconnecting main gate line 2 inside the flexible photovoltaic cell module in Example 7.

The photovoltaic cell unit in Example 7 is a single double-sided photovoltaic cell 1-1, and the exposal surface of the double-sided photovoltaic cell 1-1 of which the front surface is upward is connected with the exposal surface of the double-sided photovoltaic cell 1-1 of which the rear surface is upward through the metal foil circuit 3 on the front panel 4.

The metal foil circuit 3 on the front panel 4 is electrically connected to the electrode of the exposal surface of the photovoltaic cell through a gate line pattern circuit. The front panel 4 of the compounded metal foil circuit 3 is shown in FIG.7b.

A rigid protective plate is omitted, or a rigid protective plate is attached outside the front panel to form the rigid minimum folding unit 6.

### EXAMPLE 8

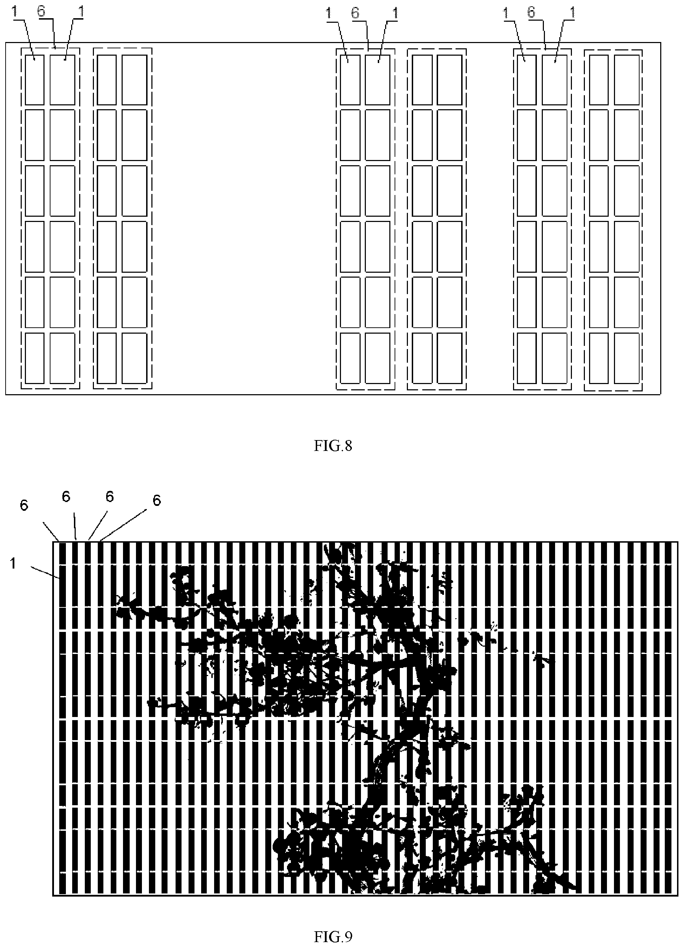

A flexible photovoltaic cell module as shown in FIG.8 is basically the same as Example 5, except that: the spacing of photovoltaic cells is non-evenly distributed.

### EXAMPLE 9

A flexible photovoltaic cell module as shown in FIG.9 is basically the same as Example 5, except that: there is a beautification and decoration layer between the front panel 4 and the photovoltaic cell layer, there is a beautification pattern on the beautification and decoration layer. The beautification pattern is located in the non-generating area that does not screen the exposal surface of the photovoltaic cell, that is, the gap area between the minimum folding unit 6. As shown in FIG. 11, there are intermittent Chinese painting patterns on the beautification and decoration layer.

The structure from top to bottom is as follows: the flexible and transparent panel 4, an encapsulation adhesive layer, a beautification and decoration layer, a plurality of minimum folding units 6, an encapsulation adhesive layer, and the rear panel 5 compounded with the metal foil circuit 3.

Or, the structure from top to bottom is as follows: the flexible and transparent panel 4, an encapsulation adhesive layer, a beautification and decoration layer, an encapsulation adhesive layer, the minimum folding units 6, an encapsulation adhesive layer, and the rear panel 5 compounded with the metal foil circuit 3.

The flexible photovoltaic module with beautification patterns can beautify the environment without affecting generation. This module can also easily curl for easy storage and transportation, and can fold and unfold many times.

### EXAMPLE 10

A flexible photovoltaic cell module as shown in this example, FIG. 10 is basically the same as Example 1, except that: the flexible circuit on the rear panel 5 is a conductive paste circuit. The rear panel 5 compounded with a conductive paste circuit is specifically a PTF flexible circuit board, and the conductive paste circuit is formed by ways of printing metallic paste on the flexible rear panel 5 through silk-screen printing.

### EXAMPLE 11

A flexible photovoltaic cell module as shown in this example, FIG. 11 is basically the same as Example 1, except that: the flexible circuit layer is the metal foil circuit between the front panel and the rear panel or the flexible flat cable compounded with a metal foil circuit or the flexible flat cable compounded with a conductive paste circuit.

The structure of the photovoltaic cell module from top to bottom is as follows: a front panel, an encapsulation adhesive layer, the rigid protective plate 6-1, an encapsulation adhesive layer under the rigid protective plate 6-1, a photovoltaic cell layer, a flexible circuit layer, an encapsulation adhesive layer and the rear panel 5.

Compared with Example 1, the encapsulation adhesive layer between the photovoltaic cell layer and the rear panel will not hinder the combination of the connecting portions of the photovoltaic cell unit and the flexible circuit layer, so there is no need to open a dodging hollow on the encapsulation adhesive layer.

### EXAMPLE 12

A flexible photovoltaic cell module as shown in this example, FIG. 12 is basically the same as Example 5, except that: completing the electrical connection between the interconnecting main gate line of the photovoltaic cell unit and the interconnecting circuit layer at the time of typesetting, soldering the interconnecting main gate line with the flexible circuit layer through welding materials such as tin, or welding them by ways of ultrasonic welding, friction welding, resistance welding, etc., after completing the welding, carrying out lamination.

### EXAMPLE 13

A flexible photovoltaic cell module as shown in this example, FIG. 13 is basically the same as Example 1, except that: one side of the exposal surface of the photovoltaic cell string 3 is covered with a protective layer of glue-drop material by ways of dropping and curing glue, and the glue-drop material is transparent epoxy resin and the likes. The glue-drop material protective layer wraps the interconnecting main gate line 2 inside itself, completely replaces the rigid protective plate 8, directly forming a rigid minimum folding unit.

### EXAMPLE 14

A flexible photovoltaic cell module as shown in this example, FIG. 14 is basically the same as Example 1, except that: the photovoltaic cell unit and the flexible circuit layer form a mechanical and electrical connection through the low-temperature curing conductive past, the low-temperature curing conductive paste is inherent in the connecting portion of the photovoltaic cell unit and the flexible circuit layer or placed on the connecting portion during typesetting.

## Claims

1. A flexible photovoltaic cell module comprising a front panel, a rear panel and a photovoltaic cell layer encapsulated between the front panel and the rear panel, wherein the front panel and the rear panel are a flexible plate, the photovoltaic cell layer includes a plurality of photovoltaic cell units, the photovoltaic cell units are connected with each other in series and parallel through a flexible circuit layer,
the photovoltaic cell unit is a single photovoltaic cell or a photovoltaic cell string, the photovoltaic cell unit is electrically connected to the flexible circuit layer through an interconnecting main gate line lead out from the photovoltaic cell inside this unit and/or through an electrode of the photovoltaic cell inside this unit,
the flexible circuit layer is a metal foil circuit or a flexible flat cable between the front panel and the rear panel,
or the flexible circuit layer is the front panel and/or the rear panel compounded with a flexible circuit.

2. The flexible photovoltaic cell module according to claim 1, wherein the photovoltaic cell layer is encapsulated between the front panel and the rear panel through an encapsulation adhesive layer, when the encapsulation adhesive layer is set between the photovoltaic cell layer and the flexible circuit layer, a dodging hollow corresponding to the electrical connection area between the photovoltaic cell unit and the flexible circuit layer is set on the encapsulation adhesive layer, the electrode and the interconnecting main gate line of the photovoltaic cell unit are electrically connected with the flexible circuit layer though the dodging hollow.

3. The flexible photovoltaic cell module according to claim 1, wherein the flexible circuit layer and the photovoltaic cell unit are welded together through low-temperature welding material or low-temperature curing conductive paste to form a mechanical and electrical connection, the welding temperature of the low-temperature welding layer matches the lamination temperature of the photovoltaic module, the curing temperature of the low-temperature curing conductive paste layer matches the lamination temperature of the photovoltaic module.

4. The flexible photovoltaic cell module according to claim 1, wherein the flexible circuit layer is electrically connected to the electrode of the photovoltaic cell through a gate line pattern circuit, or the photovoltaic cell is electrically connected with the flexible circuit layer through a side main gate electrode.

5. The flexible photovoltaic cell module according to claim 1, wherein the photovoltaic cell unit is a photovoltaic cell string composed of two double-sided photovoltaic cells, which are arranged alternately forwards and backwards, the flexible circuit layer is located on one side of the shadow surface of the photovoltaic cell layer, the exposal surfaces of the two double-sided photovoltaic cells are connected with each other through the interconnecting main gate line, and the shadow surface of the two double-sided photovoltaic cells are electrically connected to the flexible circuit layer through electrodes;
or, the photovoltaic cell unit is a single photovoltaic cell, the flexible circuit layer is located on one side of the shadow surface of the photovoltaic cell layer, the exposal surface of the photovoltaic cell is electrically connected to the flexible circuit layer through the interconnecting main gate line lead out from this surface, and the shadow surface of the photovoltaic cell is electrically connected to the flexible circuit layer through an electrode,
or, the photovoltaic cell unit is a single photovoltaic cell, the flexible circuit layer is located on one side of the shadow surface of the photovoltaic cell layer, both the exposal surface and shadow surface of the photovoltaic cell are electrically connected to the flexible circuit layer through the interconnecting main gate lines lead out these surfaces;
or, the photovoltaic cell unit is a single photovoltaic cell, both one sides of the exposal surface and shadow surface of the photovoltaic cell have a flexible circuit layer, which is the front panel and the rear panel compounded with a flexible circuit, both the exposal surface and shadow surface of the photovoltaic cell are electrically connected to the flexible circuit layer on the same side through electrodes, the flexible circuit layer is electrically connected to the electrode on the exposal surface of the photovoltaic cell through a gate line pattern circuit;
or, the photovoltaic cell unit is a single photovoltaic cell, both one sides of the exposal surface and shadow surface of the photovoltaic cell have a flexible circuit layer, which is the front panel and the rear panel compounded with a flexible circuit, both the exposal surface and shadow surface of the photovoltaic cell are electrically connected to the flexible circuit layer on the same side through electrodes, the photovoltaic cell is electrically connected to the flexible circuit layer through a side main gate electrode on the exposal surface;
or, the photovoltaic cell unit is a single back surface field cell, the flexible circuit layer is located on one side of the shadow surface of the photovoltaic cell layer, the positive and negative electrodes on the shadow surface of the photovoltaic cell are electrically connected to the flexible circuit layer, respectively.

6. The flexible photovoltaic cell module according to claim 1, wherein the flexible flat cable is a flexible flat cable compounded with a metal foil circuit or a flexible flat cable compounded with a conductive paste circuit, the flexible circuit is a metal foil circuit or a conductive paste circuit, the thickness of the metal foil circuit and the conductive paste circuit ranges from 10um to 100um.

7. The flexible photovoltaic cell module according to claim 1, wherein the photovoltaic cell layer is divided into a plurality of rigid minimum folding units, each minimum folding unit contains at least one photovoltaic cell unit, there is a folding gap between the minimum folding units.

8. The flexible photovoltaic cell module according to claim 7, wherein the minimum folding unit is formed by ways of covering a rigid protective plate on one side of the exposal surface of the photovoltaic cell, the flexible circuit layer is located on one side of the shadow surface of the photovoltaic cell layer, the rigid protective plate and the photovoltaic cell unit are bonded together through an encapsulation adhesive layer,
or the minimum folding unit is formed by ways of covering a protective layer of glue-drop material on one side of the exposal surface of the photovoltaic cell unit, the flexible circuit layer is located on one side of the shadow surface of the photovoltaic cell layer.

9. The flexible photovoltaic cell module according to claim 7, wherein the minimum folding units are arranged in a preset flexible curling direction of the module, the photovoltaic cell units within each minimum folding unit are arranged in a direction perpendicular to the preset flexible curling direction.

10. The flexible photovoltaic cell module according to claim 9, wherein the minimum folding unit is rectangular, and the apt-to-be-cleavage direction of the photovoltaic cell within the minimum folding unit is consistent with the length direction of the minimum folding unit.

11. The flexible photovoltaic cell module according to claim 7, wherein the connecting portion of the photovoltaic cell unit and the flexible circuit layer is located inside the minimum folding unit.

12. The flexible photovoltaic cell module according to claim 1, wherein the surface of the interconnecting main gate line and/or flexible circuit layer has low-temperature welding material, the flexible circuit layer and the photovoltaic cell unit are welded together through the low-temperature welding material to form a mechanical and electrical connection, the welding temperature of the low-temperature welding layer matches the lamination temperature of the photovoltaic module.

13. The flexible photovoltaic cell module according to claim 1, wherein the module further includes a beautification and decoration layer, which is located between the front panel and the rear panel, there is a beautification pattern on the beautification and decoration layer, the beautification pattern is located in the non-generating area that does not screen the exposal surface of the photovoltaic cell.

14. The flexible photovoltaic cell module according to claim 1, wherein the flexible flat cable is a FPC or PTF or FFC flexible flat cable, the front panel and/or the rear panel compounded with a flexible circuit is a FPC or PTF or FFC flexible circuit,
small electronic components of the photovoltaic cell module are integrated on the flexible circuit layer,
the photovoltaic cells inside the photovoltaic cell string are connected into a string through the interconnecting main gate line.

15. A manufacturing method of the flexible photovoltaic cell module according to claim 1, when the flexible circuit layer is a metal foil circuit or a flexible flat cable between a front panel and a rear panel, the method comprising the steps of
firstly typesetting the photovoltaic cell unit and the flexible circuit layer between the front panel and the rear panel, then carrying out lamination to obtain the photovoltaic cell module,
an electrical connection between the photovoltaic cell unit and the flexible circuit layer being formed during typesetting; or
an electrical connection between the photovoltaic cell unit and the flexible circuit layer being completed during lamination, wherein under the action of lamination temperature and pressure, the connecting portions of the photovoltaic cell unit and the flexible circuit layer are combined with each other to form a mechanical and electrical connection through low-temperature welding material or low-temperature curing conductive paste, the low-temperature welding material or low-temperature curing conductive paste is inherent in the connecting portions of the photovoltaic cell unit and the flexible circuit layer or placed on the connecting portion during typesetting;
when the flexible circuit layer is a front panel and/or a rear panel compounded with a flexible circuit, the method comprising the steps of
firstly typesetting the photovoltaic cell unit between the front panel and the rear panel, then carrying out lamination to obtain the photovoltaic cell module,
an electrical connection between the photovoltaic cell unit and the flexible circuit layer being formed during typesetting; or
an electrical connection between the photovoltaic cell unit and the flexible circuit layer being completed during lamination, wherein under the action of lamination temperature and pressure, the connecting portions of the photovoltaic cell unit and the flexible circuit layer are combined with each other to form a mechanical and electrical connection through low-temperature welding material or low-temperature curing conductive paste, the low-temperature welding material or low-temperature curing conductive paste is inherent in the connecting portions of the photovoltaic cell unit and the flexible circuit layer or placed on the connecting portion during typesetting.

16. The manufacturing method according to claim 15, wherein the preparation method of the photovoltaic cell unit includes the steps of
after concurrently connecting the photovoltaic cells of a plurality of photovoltaic cell units into a string through interconnecting main gate lines by ways of interconnecting on the same surface, cutting the interconnecting main gate lines between the photovoltaic cell units to obtain each photovoltaic cell.
